Europäisches Patentamt

European Patent Office

Office européen des brevets

(19)

(11) Publication number: **0 164 868**
**A2**

(12) # EUROPEAN PATENT APPLICATION

(21) Application number: **85303131.8**

(22) Date of filing: **02.05.85**

(51) Int. Cl.⁴: **G 11 C 17/00**

(30) Priority: **04.05.84 US 607337**

(43) Date of publication of application:
**18.12.85 Bulletin 85/51**

(84) Designated Contracting States:
**AT BE CH DE FR GB IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Briner, Michael S.**
**4051 La Mesa Lane**
**San Jose California 95124(US)**

(74) Representative: **Wright, Hugh Ronald et al,**
**Brookes & Martin High Holborn House 52/54 High**
**Holborn**
**London WC1V 6SE(GB)**

(54) **An erasable programmable read only memory.**

(57) A programmable read only memory erased by exposure to light is disclosed which includes a series of word lines, a series of bit lines, a group of memory cells, each connected to a bit line and a word line, and a word line pumping circuit which is selectively connectable to each of the word lines. A decoder is connected to each of the word lines for connecting the desired word line to the pumping circuit. The pumping circuit includes serially connected diodes between a source of programming voltage and the word line, and a clocked capacitor coupled to a node between the diodes.

EP 0 164 868 A2

AN ERASABLE PROGRAMMABLE READ ONLY MEMORY

This invention relates to erasable programmable read only memory integrated circuits. An apparatus for pumping word line voltage to enable programming of floating-gate avalanche-injection metal oxide semiconductor memories will be described by way of example.

Floating-gate avalanche-injection metal oxide semiconductor (FAMOS) memories are well known, and are one type of programmable read only memory in wide use. Such devices enable the programming of memory cells in a non-volatile manner. It is well known that such erasable programmable read only memory (EPROM) devices require relatively high voltages during programming to bring the gate voltage much higher than the drain voltage. This enables electrons to be pulled from the drain onto a floating gate where they collectively represent a bit of information. The memory cell retains the stored information until the device is exposed to sufficient ultraviolet light to cause the electrons on the floating gate to be excited and move off the gate. Because programming such devices not only requires a high word line voltage but also requires a high drain voltage and high drain current, an external high voltage power supply is required to program FAMOS EPROM's at reasonable speeds.

The requirement for such a power supply is undesirable. What is needed is apparatus for programming EPROM cells which allows the use of lower voltage power supplies while maintaining fast programming rates.

This invention provides a programmable read only memory which is erased by exposure to light, yet may be programmed with a relatively low programming voltage in a rapid manner by a pumping circuit associated with groups of word lines. In one embodiment an EPROM includes a first set of word lines; a second set of bit lines; a plurality of memory cells, each connected to a bit line and a word line; a word line pumping circuit selectively connectable to each of the word lines; and a decoder connected to each of the word lines for selectively connecting a single word line to the pumping circuit. In the preferred embodiment the pumping circuit includes first and second diodes connected in series between the programming voltage and an output terminal, with a capacitor driven by a clocked source of electrical signals coupled to the node between the diodes.

The invention is particularly advantageous as it provides a technique for pumping the word lines in a manner which lowers the programming voltage required by the EPROM while maintaining short programming times for individual cells.

Figure 1 is a schematic drawing illustrating a portion of an array of EPROM cells together with associated bit and word lines.

Figure 2 is a schematic drawing of a pumping circuit.

Figure 3 is a schematic drawing of a portion of an EPROM illustrating the manner in which the pumping circuit may be coupled to a single word line.

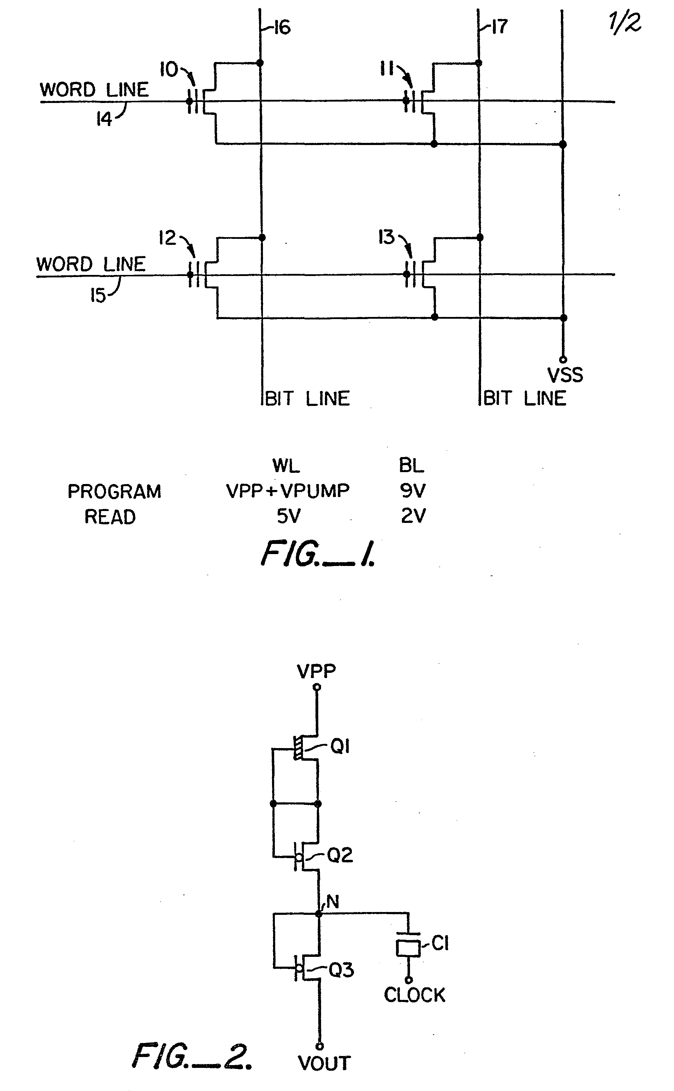

Figure 1 is an electrical schematic illustrating a portion of an array of EPROM cells. Four individual FAMOS type EPROM cells 10, 11, 12 and 13 are shown coupled to word lines 14 and 15, and to bit lines 16 and 17. As shown, each cell has a control gate coupled to the word line and its other two electrodes coupled between the bit line and ground (VSS). For example, cell 12 is coupled to word line 15 and bit line 16. The individual memory cells such as cells 10-13 are well known and have been the subject of many technical articles as well as patents. Briefly summarized, if the drain junction is driven to avalanche breakdown, high-energy electrons penetrate a relatively thick gate oxide layer and become trapped on a floating gate. The presence or absence of electrons on the floating gate may be detected by application of suitable voltages to the word line and bit lines, and in this manner the contents of the floating gate may represent a bit of information. Typical read voltages for the word line and bit line are 5 and 2 volts respectively.

To program an individual cell, the word line and the bit line are raised to sufficiently high voltage 5 to cause avalanching by which current is drawn from the bit line to place electrons on the floating gate. In conventional EPROM's programming has been accomplished by simply switchably connecting the desired word line to a relatively high voltage source, on the order of 15 volts, while coupling the appropriate bitline to about 9 volts. The present invention eliminates the need to couple the word line to such a high voltage source, and enables it to be coupled to a lower voltage source while still maintaining the ability to program individual cells of the EPROM at a rapid rate. This is achieved by switchably connecting the word line to a lower potential source and then pumping the word line with a pumping circuit to raise it to a sufficiently high potential to rapidly program the desired cell. In this manner the cells may be programmed with a lower word line voltage given by:

$$V(WL\ programming) = VPP + VPUMP$$

where VPP is the supplied programming voltage and VPUMP is the additional potential supplied by the pumping circuit.

A preferred embodiment of the word line pumping circuit of this invention is shown in Figure 2. As shown there the circuit includes three transistors, Q1, Q2, and Q3, and a capacitor C1. Transistor Q1 is a depletion device having a threshold voltage of approximately minus three volts. Transistors Q2 and Q3 are intrinsic transistors having a threshold voltage of about zero volts. Transistors Q1 and Q2 have sources and drains serially connected between a first node N and a source of programming potential VPP, typically on the order of 12.5 volts. The gates of transistors Q1 and Q2 are coupled together and to a node between them. Coupled in this manner transistor Q2 effectively forms a diode which permits current to flow from VPP toward node N, but not in the reverse direction. Depletion device Q1 provides a load resistance, which limits the current to unselected pumping circuits.

Transistor Q3 is coupled between an output terminal VOUT and node N, with its gate also coupled to node N. Transistor Q3 effectively forms a diode which permits current to flow only from node N toward terminal VOUT, and not in the reverse direction. Also coupled to node N is one terminal of capacitor C1. The other terminal of capacitor C1 is coupled to a source of clocked electrical signals, typically a switched 5 volt supply.

Neglecting losses, the circuit shown in Fig. 2 operates in the following manner. When the clock signal applied to capacitor C1 is low, node N will be initially at approximately VPP, typically 12.5 volts. When the clock signal applied to capacitor C1 goes high, for example, to 5 volts, node N will be raised above VPP, theoretically to 17.5 volts (12.5 volts + 5 volts). This will raise the output voltage at terminal VOUT above VPP, theoretically to 17.5 volts. When the capacitor clock signal returns to zero volts, node N will drop to 12.5 volts or VPP, but diode Q3 will be cut off, holding terminal VOUT at a voltage above VPP. Practically, the word line voltage at terminal VOUT will be given by the following expression:

VOUT = VPP + B (delta V pumping clock) - 2 diode drops where B is the ratio of the pumping capacitor to the sum of the parasitic capacitance on the pumped node and the pumping capacitor.

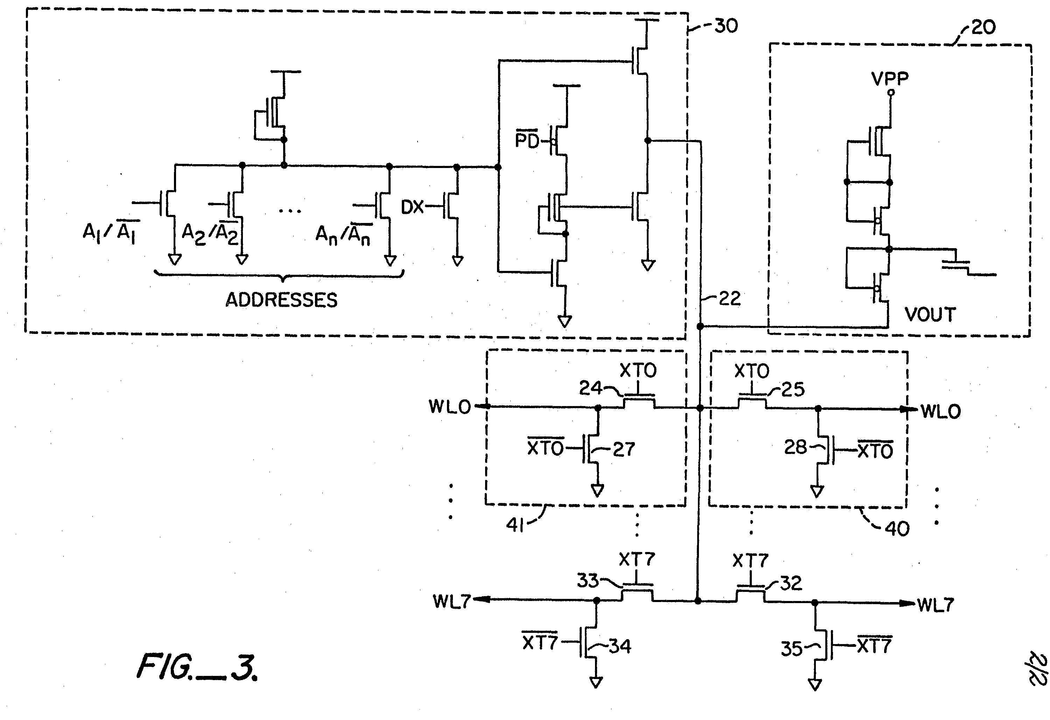

Because a single EPROM cell is extremely small, and the pumping circuitry relatively large, it is desirable for the pumping circuit to be shared by several word lines. In the preferred embodiment the pump circuit of Figure 2 is shared by eight word lines in the manner illustrated by Figure 3. As shown in Figure 3 the pumping circuit 20 of Figure 2 is coupled to line 22 which is coupled to each one of a sequence of word lines WL0, WL1 (not shown) ... WL7. Also connected to each word line is a well known decoding circuit 30 for reading and writing to individual cells.

Each word line also includes one or more pairs of decoding transistors 40 coupled between the word line WL0 with its associated individual EPROM cells and the pumping circuit 20. For the circuit shown in Figure 3 two pairs of transistors 40 and 41 are shown separating the pumping circuit 20 from the ends of the word line to which cells are connected. Depending upon the physical arrangement of the memory, the particular location of the pumping circuit 20, and losses in the word lines, more or fewer word lines may be coupled to the individual pumping circuit through more or fewer pairs of transistors.

The operation of the pairs of decoding transistors 40, 41 is as follows. If it is desired to program one or more cells, for example, coupled to word line WL7, a well known decoder is used to generate a decoded signal XT7 which is supplied to the gates of transistors 32 and 33. By virtue of the decoder signal XT7 will be high and all other XT0-XT6 signals will be low. Thus only transistors 32 and 33 will be on and all other transistors receiving XT signals will be off, for example, transistors 24 and 25.

The complementary signal $\overline{XT7}$ will be low disconnecting word line WL7 from ground by turning off transistors 34 and 35. Because the other complementary signals $\overline{XT0}$-$\overline{XT6}$ will all be high, corresponding transistors associated with every other word line WL0-WL6 will be turned on connecting those word lines to ground. For example, transistors 27 and 28 will be on to connect word line WL0 to ground. In this manner pumping circuit 20 will only pump the addressed word line WL7, in the example above.

To ensure that the high voltage from the pumping circuit 20 is passed to the word line, the XT signals themselves are pumped using a pump like that described in conjunction with Figure 2. The signals XT0-XT7 are pumped to be at least one MOS device threshold above the pumped word line voltage. This is achieved by pumping the XT signals themselves with a clock that has a wider voltage range than the clock coupled to the capacitor in the word line pump of Figure 2.

The above described circuitry of this invention enables the fabrication of an EPROM which can be programmed by an externally applied programming voltage lower than the voltage applied internally to the EPROM word lines without sacrificing programming speed. Although the above invention has been described with reference to a preferred embodiment, it should be understood that the scope of the invention is defined by the appended claims.

CLAIMS

I claim:

1. A programmable read only memory erased by exposure to light comprising:

a first plurality of word lines;

a second plurality of bit lines;

a plurality of memory cells, each connected to a bit line and a word line;

a word line pumping circuit selectively connectable to each of the word lines; and

a decoder connected to each of the word lines for selectively connecting a single word line to the pumping circuit.

2. Apparatus as in claim 1 wherein the word line pumping circuit comprises:

first diode means connected between a first source of electrical signals and a first node;

second diode means connected between an output terminal and the first node; and

capacitor means connected between a clocked source of electrical signals and the first node.

3. Apparatus as in claim 2 wherein the first and second diode means permit electrical current to flow toward the output terminal but not toward the first source of electrical signals.

4. Apparatus as in claim 3 wherein the first diode means comprises a first intrinsic field effect transistor connected between the first node and the source of electrical signals.

5. Apparatus as in claim 4 wherein the second diode means comprises a second intrinsic field effect transistor connected between the first node and the output terminal.

6. Apparatus as in claim 2 wherein the word line pumping circuit further comprises current limiting means connected between the first diode means and the first source of electrical signals.

7. Apparatus as in claim 6 wherein the current limiting means comprises a depletion mode transistor.

8. Apparatus as in claim 1 wherein the decoder comprises a plurality of pairs of transistors, each pair coupled to a different word line and connected to receive address signals.

9. Apparatus as in claim 8 wherein:
a first transistor of each pair is connected between the pumping circuit and the memory cells; and
a second transistor of each pair is connected between the word line and ground.

10. Apparatus as in claim 9 wherein a first address signal is supplied to the first transistor of each pair and a complementary address signal is simultaneously supplied to the second transistor of each pair.

11. Apparatus as in claim 10 wherein the address signal is coupled to a second pumping circuit.

| | WL | BL |
|---|---|---|
| PROGRAM | VPP+VPUMP | 9V |
| READ | 5V | 2V |

*FIG.__1.*

*FIG.__2.*

FIG._3.